# EUROPEAN PATENT APPLICATION

(11) **EP 4 663 808 A1**
(43) Date of publication of application: **17.12.2025**
(21) Application number: 24753325.0
(22) Date of filing: 05.02.2024
(51) Int. Cl.: C23C 14/06, C01G 41/00, C23C 14/08

(54) **TRANSPARENT HEAT-RAY REFLECTIVE FILM AND METHOD FOR MANUFACTURING TRANSPARENT HEAT-RAY REFLECTIVE FILM**

(30) Priority: 07.02.2023 JP 2023016778
(71) Applicant: SUMITOMO METAL MINING CO., LTD., Tokyo 105-8716 (JP)
(72) Inventor: ADACHI, Kenji, Tokyo 105-8716 (JP); OKAMI, Hideharu, Tokyo 105-8716 (JP)
(74) Representative: Jones, Nicholas Andrew
(86) International application number: PCT/JP2024/003774
(87) International publication number: WO 2024/166882

(57) **Abstract**

A transparent heat-ray reflective film is a continuous film of a material that realizes plasmonic 5 reflection, and is non-conductive.

## Description

### TECHNICAL FIELD

The present invention relates to a transparent heat-ray reflective film and a method for manufacturing a transparent heat-ray reflective film.

### BACKGROUND OF THE INVENTION

Window members, such as plate glass provided with a film that transmits visible light and shields near-infrared rays functioning as heat rays, are used for windows of automobiles, windows of buildings, and the like. Such window members are roughly classified into absorption-type infrared shielding films and reflection-type infrared shielding films. The absorption-type infrared shielding film includes an infrared absorbing particle dispersion material provided on a surface of a transparent substrate, such as plate glass. In the infrared absorbing particle dispersion material, infrared absorbing material particles are dispersed in a resin transparent to visible light. The reflection-type infrared shielding film includes an infrared reflective film provided on a surface of a transparent substrate, such as plate glass.

The applicant has proposed an absorption-type infrared shielding film in Patent Documents 1 and 2. The absorption-type infrared shielding film exhibits electrical insulation, and therefore, as described later, the absorption-type infrared shielding film does not reflect radio waves used for communications or the like. When the absorption-type infrared shielding film is used for a window, radio waves used for communications or the like are transmitted into a room, and a communication failure of a mobile phone or the like does not occur. However, the absorption-type infrared shielding film has a problem such that the infrared rays absorbed by the absorption-type infrared shielding film when receiving solar radiation heat up the substrate or the dispersion material.

In many cases, the reflection-type infrared shielding film utilizes plasmonic reflection, which is realized by a film having metallic conductivity, for reflection of heat rays. The most desired reflection characteristics are obtained by a thin film formed by Ag sputtering. In order to improve visible light transmittance, a multilayer film composed of Ag and a dielectric is used as the reflection-type infrared shielding film (Patent Documents 3 and 4).

The problem of these transparent heat-ray reflective films having high conductivity, serving as the reflection-type infrared shielding films, is that such films reflect radio waves used for mobile phones or various information transmissions. As the popularity of electric vehicles increases, heat-ray shielding is becoming essential for reducing an air conditioning load to increase a cruising distance. At the same time, windows of vehicles are required to have transparency to various sensor signals in view of comfort in the vehicles and autonomous driving. Radio waves of wireless signals or FM radio belong to the VHF band (30 MHz to 0.3 GHz).

Radio waves for mobile phones or mobile communications belong to the UHF band (0.3 GHz to 3 GHz). Particularly useful radio waves for communications are in the frequency band of 0.9 GHz to 2.2 GHz, and radio waves used for a wireless local area network (wireless LAN) is in the band of 2.45 GHz or in the band of 5.2 GHz. For high-speed communications and satellite communications, technical development has been carried out with an aim of using the SHF band (3 GHz to 30 GHz), which includes even shorter wavelengths.

Therefore, it is preferable that a transparent heat-ray reflective film can transmit radio waves in the above frequency bands. However, a transparent heat-ray reflective film including a thin metallic film reflects radio waves in the GHz band or the MHz band used for signal transmissions of the above communications, and therefore it is necessary to take measures such as formation of notches in part of the film. This situation applies not only to the metal films, but also to a transparent heat-ray reflective film using a transparent conductive oxide, such as indium-tin-oxide (ITO), in which indium oxide is doped with tin by several mol%, zinc oxide doped with Al or Ga by several mol% (AZO or GZO), and the like.

In order to secure the radio wave signal transmittance, a transparent heat-ray reflective film is desired to have a high resistance, at least as a surface resistance. However, as a transparent heat-ray reflective film using plasmonic reflection of metal, a film that has a high surface resistance and transmits radio waves has not yet existed. Thus, there is a need for a novel transparent heat-ray reflective film that has a high surface resistance and transmits radio waves.

### RELATED-ART DOCUMENT

### Patent Document

Patent Document 1: International Publication No. WO2005/037932
Patent Document 2: International Publication No. WO2005/087680
Patent Document 3: Japanese Patent Application Laid-Open No. S62-41740
Patent Document 4: Japanese Patent Application Laid-Open No. 2006-117482

### Non-Patent Document

Non-Patent Document 1: Hiroshi Ito, Keisuke Tanaka, Yuji Yamamoto, Yasuo Hashimoto, and Hiroshi Kurihara, "Improvement of TV Radio Wave Reflecting Characteristics in High Performance High-Reflective Glass," ITEJ Technical Report, Vol. 15, pp. 15-21 (1991)
Non-Patent Document 2: Keiichi Sato, Isao Ando, Satoshi Yoshio, and Kenji Adachi, "Cesium polytungstate in sputtered solar control films. I. Microstructure and optical properties," Journal of Applied Physics, Vol. 130, 113102 (2021)
Non-Patent Document 3: Shuhei Nakakura, Aditya Farhan Arif, Keisuke Machida, Kenji Adachi, and Takashi Ogi, "Cationic defect engineering for controlling the infrared absorption of hexagonal cesium tungsten bronze nanoparticles," Inorganic Chemistry, Vol. 58, 9101-9107 (2019)
Non-Patent Document 4: Satoshi Yoshio, Mika Okada, and Kenji Adachi, "Destabilization of Pseudo Jahn-Teller Distortion in Cesium-doped Hexagonal Tungsten Bronzes," Journal of Applied Physics, Vol. 124, 063109 (2018).
Non-Patent Document 5: Naomi Suzuki, Kayo Yabuki, Nobumitsu Oshimura, Satoshi Yoshio, Kenji Adachi, "X-ray photoelectron spectroscopic study of reduced alkali tungsten oxides with localized and delocalized electrons," Journal of Physical Chemistry C, Vol. 126, 15436-15445 (2022)

### SUMMARY OF THE INVENTION

### PROBLEMS TO BE SOLVED BY THE INVENTION

In view of the above problems of the related art, one aspect of the present invention aims to provide a transparent heat-ray reflective film having a high surface resistance.

### MEANS FOR SOLVING THE PROBLEMS

According to one aspect of the present invention, there is provided a transparent heat-ray reflective film, which is a continuous film of a material that realizes plasmonic reflection, and is non-conductive.

### EFFECTS OF THE INVENTION

According to one aspect of the present invention, a transparent heat-ray reflective film having a high surface resistance can be provided.

### BRIEF DESCRIPTION OF THE DRAWINGS

[Fig. 1] Fig. 1 depicts a transmittance spectrum and reflectance spectrum of the transparent heat-ray reflective film of Example 1.
[Fig. 2] Fig. 2 depicts a W-4f XPS spectrum of the transparent heat-ray reflective film of Example 1, and four components obtained by peak separation.
[Fig. 3] Fig. 3 is an O-1s XPS spectrum of the transparent heat-ray reflective film of Example 1, and four components obtained by peak separation.
[Fig. 4] Fig. 4 is XRD profiles of the transparent heat-ray reflective films of Examples 1 to 7 and Cs_{0.32}WO₃ reference data (ICDD83-1334).
[Fig. 5] Fig. 5 depicts a transmittance spectrum and a reflectance spectrum of the transparent heat-ray reflective film of Example 2.
[Fig. 6] Fig. 6 depicts a transmittance spectrum and a reflectance spectrum of the transparent heat-ray reflective film of Example 3.
[Fig. 7] Fig. 7 depicts a transmittance spectrum and a reflectance spectrum of the transparent heat-ray reflective film of Example 4.
[Fig. 8] Fig. 8 depicts a transmittance spectrum and a reflectance spectrum of the transparent heat-ray reflective film of Example 5.
[Fig. 9] Fig. 9 depicts a transmittance spectrum and a reflectance spectrum of the transparent heat-ray reflective film of Example 6.
[Fig. 10] Fig. 10 depicts a transmittance spectrum and a reflectance spectrum of the transparent heat-ray reflective film of Example 7.
[Fig. 11] Fig. 11 depicts a transmittance spectrum and a reflectance spectrum of the film of Comparative Example 1.
[Fig. 12] Fig. 12 depicts a transmittance spectrum and a reflectance spectrum of the film of Comparative Example 2.
[Fig. 13] Fig. 13 depicts a transmittance spectrum and a reflectance spectrum of the film of Comparative Example 3.
[Fig. 14] Fig. 14 depicts XRD profiles of the films obtained in Comparative Examples 1 to 3 and Cs_{0.32}WO₃ reference data (ICDD83-1334).
[Fig. 15] Fig. 15 is a photograph depicting appearance of the transparent heat-ray reflective films obtained in Examples 1 to 7, and the films obtained in Comparative Examples 1 to 3.

### DETAILED DESCRIPTION OF THE INVENTION

Specific examples of the transparent heat-ray reflective film and the method for manufacturing the transparent heat-ray reflective film according one embodiment of the present disclosure (referred to as the "present embodiment" hereinafter) will be described with reference to drawings. The present invention is not limited to these examples. The present invention is defined by the scope of the claims, and is construed as including all modifications within the meaning and scope equivalent to the scope of the claims.

### [Transparent heat-ray reflective film]

The transparent heat-ray reflective film of the present embodiment is a continuous film of a material that realizes plasmonic reflection, and is non-conductive.

### (1) Material that realizes plasmonic reflection

Plasmonic reflection is a phenomenon that originally occurs in a system including a large amount of free electrons, such as a metal. The presence of a large amount of free electrons typically imparts a high level of conductivity to a material, but the film of the present embodiment is non-conductive. Thus seemingly contradictory physical properties are a central feature of the present embodiment.

In the present invention, the material that realizes plasmonic reflection refers to a material having a characteristic such that the material reflects incident electromagnetic waves due to collective excitation of free electrons, and having the maximum reflectance of 30% or greater in the wavelength range of 780 nm or longer and 2,600 nm or shorter. Ideally, incident electromagnetic waves having wavelengths longer than the wavelength λp (= 2π/ω_{P}) defined by the plasma frequency ω_{P} = 4πNe²/m (N: free electron density (1/cm⁻³), m: mass of electrons (g)) are reflected 100%. In practice, however, attenuation of reflection and a change in intensity according to a wavelength occurs due to crystal imperfections, lattice defects, impurities, and the like in the material. Therefore, in the present invention, the continuous film of the material that realizes plasmonic reflection is defined as a material having the maximum value of the plasmonic reflection, i.e., the maximum reflectance, being 30% or greater in the wavelength range of 780 nm or greater and 2,600 nm or less, considering industrial effectiveness.

The non-conductivity means that a surface resistance of the film is 10⁵ Ω/sq or greater. In the present specification, the film having the surface resistance of 10⁵ Q/sq or greater can be evaluated as having a high surface resistance.

The radio wave reflection characteristics are closely related to the surface resistance of the film. Generally, the larger the surface resistance is, the higher the radio wave transmittance is. At the surface resistance of 10⁵ Ω/sq or greater, a considerable level of the radio wave transmittance in the VHF band or the UHF band occurs. At the surface resistance of 10⁶ Ω/sq or greater, radio wave transmittance comparable to that of float glass can be obtained with respect to all radio waves in the VHF band, the UHF band, and the SHF band (Non-Patent Document 1).

Accordingly, from the standpoint of securing radio wave signal transmittance, the transparent heat-ray reflective film has the surface resistance of preferably 10⁵ Q/sq or greater, and more preferably 10⁶ Ω/sq or greater.

The material that realizes plasmonic reflection used in the transparent heat-ray reflective film of the present embodiment is not particularly limited, but preferably includes alkali tungsten bronze that provides a hexagonal crystal pattern as measured by powder X-ray diffraction. The material that realizes plasmonic reflection preferably includes, as a main component, the alkali tungsten bronze that provides a hexagonal crystal pattern as measured by powder X-ray diffraction. The alkali tungsten bronze being included as a main component means that the alkali tungsten bronze is included in the largest mass ratio. The material that realizes plasmonic reflection may be composed of the alkali tungsten bronze that provides a hexagonal crystal pattern as measured by powder X-ray diffraction. Even in this case, the inclusion of inevitable impurities is not excluded. The alkali tungsten bronze refers to tungsten bronze including an alkali metal element.

Part of the tungsten bronze including the alkali metal element can have a hexagonal crystal structure. It has recently been revealed that this hexagonal crystal structure has lattice defects on the basal plane and the prismatic plane, and it has been reported that, when these defects are included, an excess diffraction line appears in addition to diffraction lines of the hexagonal crystal pattern in powder X-ray diffraction (Non-Patent Document 2).

Regardless of the presence or absence of the excess diffraction line, the material that realizes plasmonic reflection used in the transparent heat-ray reflective film of the present embodiment can include alkali tungsten bronze that basically provides a hexagonal crystal pattern in powder X-ray diffraction. Specifically, in the present specification, the alkali tungsten bronze that provides a hexagonal crystal pattern may be alkali tungsten bronze having the hexagonal crystal structure with lattice defects or alkali tungsten bronze having the hexagonal crystal structure without a lattice defect.

In the transparent heat-ray reflective film of the present embodiment, the alkali tungsten bronze included in the material that realizes plasmonic reflection is preferably represented by a general formula: AₓW_{y}O_{z} (0.05 ≤ x/y ≤ 0.5, 2.5 ≤ z/y ≤ 3.0, and the element A includes at least one alkali metal element selected from the group consisting of Na, K, Rb, and Cs).

The element A may further include an element other than the above alkali metal elements. For example, the element A can further include at least one additive element (substituting element) selected from the group consisting of Tl, In, Li, Be, Mg, Ca, Sr, Ba, Al, Ga, and Ti. The proportion or ratio of the above additive element included in the metal A is not particularly limited, and may be appropriately selected according to desired properties or the like.

It has been known that nano particles of the alkali tungsten bronze having the above composition function as heat-ray absorbing particles having excellent transparency when the nano particles are dispersed in a medium, such as an acrylic, to form a film (Patent Documents 1 and 2).

Both free electrons and localized electrons are present in crystals of the alkali tungsten bronze included in the transparent heat-ray reflective film of the present embodiment. In the alkali tungsten bronze included in the transparent heat-ray reflective film of the present embodiment, a ratio of localized electrons W⁵⁺ to all of the W atoms is preferably 0.20 or greater.

W⁴⁺ may be included in the localized electrons, but most of the localized electrons in the hexagonal alkali tungsten bronze are observed as W⁵⁺. The localized electrons of the hexagonal alkali tungsten bronze can be confirmed by X-ray photoelectron spectroscopy (XPS).

Specifically, a photoelectron spectrum of the hexagonal alkali tungsten bronze included in a sample is measured by X-ray photoelectron spectroscopy, and a W4f spectrum of a tungsten atom is split into constituent components by peak separation so that the W⁵⁺ spectrum can be confirmed. As constituent components, W⁶⁺, W⁵⁺, W⁴⁺, W, and the like are included. Then, the ratio of the area of the W⁵⁺ spectrum to the area of the W4f spectrum of the tungsten atoms of the photoelectron spectrum is determined as the ratio of the localized electrons W⁵⁺ to all of the W atoms.

The presence of many localized electrons in the hexagonal alkali tungsten bronze causes a potential perturbation and reduces the mobility of free electrons, which are a major cause of non-conductivity of the film. The effect of metal-insulator transition caused together with the increase of localized electrons is considered to be a phenomenon related to an insulation mechanism in a disorder system, which is called Anderson transition, or an insulation mechanism in a strongly correlated electron system, which is called Mott transition. On the other hand, localized electrons W⁵⁺ are bound by W ions, and are not free electrons that can basically move freely. However, localized electrons W⁵⁺ contribute to generation of plasmonic reflection of near-infrared rays together with free electrons through some mechanism. In the transparent heat-ray reflective film of the present embodiment, a ratio (value of W⁵⁺/W) of localized electrons W⁵⁺ to all of the W atoms in the crystals of the alkali tungsten bronze is preferably 0.20 or greater, more preferably 0.30 or greater, and yet more preferably 0.40 or greater. Since the ratio (value of W⁵⁺/W) of the localized electrons W⁵⁺ to all of the W atoms in the crystals of the alkali tungsten bronze is 0.20 or greater, conductivity of the transparent heat-ray reflective film can be suppressed, and the surface resistance is easily adjusted to 10⁵ Q/sq or greater.

In view of enhancement of non-conductivity, the transparent heat-ray reflective film of the present embodiment is preferably a film having the preferred orientation in which the (0001) planes, which are hexagonal basal planes of the crystals of the alkali tungsten bronze, are oriented to be parallel to the film surface. Specifically, the peak diffraction intensity ratio I₀₀₀₂/I₂₀₋₂₀ of the X-ray diffraction pattern is preferably greater than the same peak diffraction intensity ratio I₀₀₀₂/I₂₀₋₂₀ of a sample in which crystals are not oriented.

For example, the alkali tungsten bronze included in the transparent heat-ray reflective film of the present embodiment is assumed to be Cs_{0.32}WO₃. In this case, a peak diffraction intensity ratio I₀₀₀₂/I₂₀₋₂₀ of a reference powder pattern (ICDD 83-1334), which is a sample without crystal orientation, can be determined as a reference intensity ratio (p_{std}). The transparent heat-ray reflective film of the present embodiment is preferably a film with which the peak diffraction intensity ratio p = I₀₀₀₂/I₂₀₋₂₀ of the X-ray diffraction pattern of the alkali tungsten bronze included in the transparent heat-ray reflective film of the present embodiment is greater than p_{std}. Specifically, the transparent heat-ray reflective film of the present embodiment is preferably a film satisfying p > p_{std}.

The crystal anisotropy of the alkali tungsten bronze affects the charge transport phenomenon in the film. According to the density functional theory (DFT) calculation, the charge distribution in the c-axis direction is delocalized, but the charge distribution in the a-axis and b-axis directions is basically localized and partially delocalized (Non-Patent Document 4). In the case where the (0001) plane orientation is present, the charge transport on the film surface is inhibited to thereby increase the surface resistance. In the case where the film has the a-axis orientation, on the other hand, the a-axis orientation contributes to a decrease in the surface resistance.

There are various methods for grasping the crystal orientation in the film, but the simplest method is to evaluate an XRD powder diffraction pattern as described above. In the case of the c-axis orientation of the hexagonal crystal, for example, the crystal orientation can be evaluated by a ratio of the diffraction intensity at the peak of the (0002) plane, which is the c-plane, to the diffraction intensity at the peak of the (20-20) plane, which is the a-plane. Taking hexagonal Cs_{0.32}WO₃ as an example, p_{std} = 246/999 = 0.246 in the pattern (ICDD 83-1334) of the reference powder that is a sample without crystal orientation, and when the value of p is larger than the value of p_{std}, it is considered that the c-axis orientation is present in the film. The film that satisfies p > p_{std} has a relatively high surface resistance compared to the film without crystal orientation.

### (2) Regarding characteristics of transparent heat-ray reflective film

### (Optical characteristics)

The transparent heat-ray reflective film of the present embodiment preferably has optical characteristics such that visible light transmittance is preferably 5% or greater, more preferably 10% or greater, and yet more preferably 20% or greater, and reflectance at a wavelength 1,400 nm in the near-infrared region is 30% or greater.

The transmittance of glass windows used industrially varies widely. For example, a wide range of visible light transmittance, which is the order of 20% to 70% or greater, is used for windows for automobiles. For example, front windshields or front-door glass windows are regulated to have visible light transmittance of 70% or greater, or 75% or greater depending on the country. On the other hand, glass having low visible light transmittance, which is from the order of 20% to 30%, is used for rear-door glass windows or back windows in view of protection of privacy.

By applying the transparent heat-ray reflective film of the present embodiment for, for example, a glass substrate, the glass having a high heat-ray reflection performance with a wide range of visible light transmittance from low visible light transmittance to high visible light transmittance can be provided.

### (Surface resistance)

As described above, windows of automobiles or the like are required to have transmittance with respect to radio waves used for communications or the like. Therefore, the surface resistance of the transparent heat-ray reflective film of the present embodiment is preferably 10⁵ Q/sq or greater, and more preferably 10⁶ Ω/sq or greater.

Since the surface resistance of the transparent heat-ray reflective film is in the above range, transmittance with respect to radio waves used for communications or the like can be increased. The upper limit of the surface resistance of the transparent heat-ray reflective film is not particularly limited, but the upper limit is preferably, for example, 10¹¹ Ω/sq or less.

### (Moisture content)

The moisture content of the transparent heat-ray reflective film of the present embodiment is preferably 5.0 mol% or less. The moisture content of the film is more preferably 0.05 mol% or greater and 5.0 mol% or less, yet more preferably 0.05 mol% or greater and 4.0 mol% or less, and particularly preferably 0.05 mol% or less and 3.0 mol% or less.

The alkali tungsten bronze has a characteristic such that various molecules derived from water, such as O, OH, OH₂, H₃O, and the like, or excess oxygens are easily inserted into a basal plane or prismatic planes of the crystal of the alkali tungsten bronze. When water-derived molecules or excess oxygen atoms are inserted, a lattice defect where W is lost is formed in the basal plane or the prismatic plane. The valence electrons of W are a main source of free electrons and localized electrons of the alkali tungsten bronze, and a cause of film conductivity or optical functions through oxygen vacancy. Therefore, the surface resistance is significantly reduced by the W defects, and reflection or absorption function with respect to near-infrared rays may be impaired. The above dry continuous film is invented and disclosed as a transparent heat-ray absorption film (Patent Document 4). The W defects are actually observed by an STEM high-angle annular dark-field scanning (HAADF) with high definition (Non-Patent Documents 2 and 3). By setting the moisture content of the film to 5.0 mol% or less, the amount of W defects introduced can be minimized, and a high infrared ray reflection function owing to plasmonic reflection can be realized.

### (Film thickness)

The film thickness of the transparent heat-ray reflective film of the present embodiment is not particularly limited, but the film thickness of the transparent heat-ray reflective film is preferably 10 nm or greater and 600 nm or less. As described later, the transparent heat-ray reflective film of the present embodiment is a film obtained by pulsed laser deposition, sputtering, or the like, and therefore a thin film can be uniformly formed without using a dispersing agent or a medium resin.

By setting the film thickness of the transparent heat-ray reflective film of the present embodiment to 10 nm or greater, a transparent heat-ray reflective film having high heat-ray reflectance can be provided. By setting the film thickness to 10 nm or greater, formation of an island film is inhibited, and unevenness in the reflection characteristics can be also inhibited.

By setting the film thickness of the transparent heat-ray reflective film of the present embodiment to 600 nm or less, visible light transmittance can be increased, and coloring of the film can be inhibited. In addition, an amount of a target used during production can be minimized so that a form formation time can be shortened, thereby increasing productivity.

### [Method for manufacturing transparent heat-ray reflective film]

Next, one configuration example of the method for manufacturing the transparent heat-ray reflective film of the present embodiment will be described. According to the method for manufacturing the transparent heat-ray reflective film of the present embodiment, the above-described transparent heat-ray reflective film can be manufactured. Therefore, the description of the features already described will be partially omitted.

The transparent heat-ray reflective film of the present embodiment can be produced, for example, by dry film formation. Therefore, the method for manufacturing the transparent heat-ray reflective film of the present embodiment can include a film formation step of forming a film of a material that realizes plasmonic reflection as a non-conductive continuous film on a surface of a substrate through dry film formation.

### (Regarding film formation raw materials)

The material that realizes plasmonic reflection preferably includes alkali tungsten bronze that provides a hexagonal crystal pattern in powder X-ray diffraction. As described above, the alkali tungsten bronze is preferably represented by the general formula: AₓW_{y}O_{z} (0.05 ≤ x/y ≤ 0.5, 2.5 ≤ z/y ≤ 3.0, and the element A includes at least one alkali metal element selected from the group consisting of Na, K, Rb, and Cs).

Therefore, for example, a tungsten source and an alkali metal element source that can constitute alkali tungsten bronze can be used as raw materials used in dry film formation. Moreover, as a raw material used in dry film formation, a composite tungsten oxide having a specific composition can be also used.

As the tungsten source, at least one selected from the group consisting of tungsten and a tungsten compound can be used.

As the alkali metal element source, at least one selected from the group consisting of an alkali metal element compound and a hydrate of an alkali metal element compound can be used.

Examples of a raw material of the tungsten source include tungsten acid (H₂WO₄). A tungsten trioxide powder obtained by firing tungsten acid may be used as a raw material of the tungsten source, or commercially available tungsten trioxide powder may be used.

As the tungsten source, tungsten oxide or a composite tungsten oxide may be also used. As the tungsten oxide, a tungsten oxide powder represented by WₐO_{b} (provided that W is tungsten, O is oxygen, and 2.2 ≤ b/a ≤ 3.0) may be used. As the composite tungsten oxide, for example, a composite tungsten oxide powder represented by a general formula: Aₓ₁W_{y1}O_{z1} (provided that A is the element A, W is tungsten, O is oxygen, 0.001 ≤ x1/y1 ≤ 1, and 2.2 ≤ z1/y1 ≤ 3.0) may be used.

As the raw material used for forming a film, for example, a raw material in which a tungsten source and an alkali metal element source are mixed so that a formed film has a target composition is preferably used.

Therefore, as the raw materials, for example, a mixture of the tungsten source and the alkali metal element source can be used. More specific examples of the raw materials include a powder mixture in which tungsten acid (H₂WO₄) and at least one selected from the group consisting of an oxide of an alkali metal element and a hydroxide of an alkali metal element are mixed, and a powder mixture in which tungsten trioxide and at least one selected from the group consisting of an oxide of an alkali metal element and a hydroxide of an alkali metal element are mixed.

Each of the tungsten source and the alkali metal element source is not necessarily composed of one material, and may be a mixture of multiple materials. Therefore, a powder mixture in which a mixture of tungsten acid (H₂WO₄) and a tungsten trioxide powder, and at least one selected from the group consisting of an oxide of an alkali metal element and a hydroxide of an alkali metal element are mixed may be used as raw materials.

Moreover, the tungsten source and the alkali metal element source are not limited to solid materials. For example, a dry powder is obtained by mixing at least one selected from the group consisting of tungsten acid (H₂WO₄) and a tungsten trioxide powder, with at least one selected from the group consisting of an aqueous solution of a metal salt including an alkali metal element, a colloidal solution of a metal oxide, and an alkoxy solution, and drying the mixture. The dry powder is fired in an inert gas atmosphere or a mixed gas atmosphere of an inert gas and a reducing gas. The resultant powder product may be used as a raw material.

In the case where the dry powder obtained by mixing and drying at least one selected from the group consisting of tungsten acid (H₂WO₄) and a tungsten trioxide powder with at least one selected from the group consisting of an aqueous solution of a metal salt including an alkali metal element, a colloidal solution of a metal oxide, and an alkoxy solution is used, a counterion for forming the metal salt is not particularly limited. Examples of the counterion include nitrate ions, sulfate ions, chloride ions, carbonate ions, and the like. A drying temperature and a drying time are not particularly limited.

In the case where a composite tungsten oxide represented by the general formula: AₓW_{y}O_{z} is used as a raw material used in film formation, as described above, the element A can include at least one alkali metal element selected from the group consisting of Na, K, Rb, and Cs. The element A may further include at least one element selected from the group consisting of Tl, In, Li, Be, Mg, Ca, Sr, Ba, Al, Ga, and Ti.

### (Regarding film formation method)

The transparent heat-ray reflective film can be formed, for example, using a pellet obtained by molding the above raw materials or a target obtained by firing the above raw materials.

The alkali tungsten bronze is not in a thermodynamic equilibrium phase, but is a non-equilibrium material that is in a weakly reduced state. Therefore, a method in which the atmosphere for the film formation process can achieve substantially weak reduction can be suitably used.

Therefore, in the method for manufacturing a transparent heat-ray reflective film of the present embodiment, at least one selected from the group consisting of magnetron sputtering, ion-beam sputtering, direct current sputtering, radio frequency sputtering, pulse sputtering, dual magnetron sputtering, electron beam physical vapor deposition, and pulsed laser deposition, all of which use a target including an alkali metal element and tungsten that constitute the alkali tungsten bronze is preferably used for dry film formation.

In the case where film formation by sputtering using a sputtering target is used as a method of dry film formation, direct current sputtering, in which direct current voltage is applied to a target, is preferably used as long as conductivity of the target is obtained depending on target production conditions. This is because direct current sputtering uses a simple power source configuration, and excels in productivity.

Even in the case where the target does not have conductivity, dry film formation can be performed by radio frequency sputtering, pulse sputtering, dual magnetron sputtering, or ion-beam sputtering.

The pulsed laser deposition (PLD) is a film formation method in which a raw material target set inside a vacuum chamber is irradiated with laser light applied from outside of the vacuum chamber so that atoms or molecules are peeled off (ablated) from the target, and a thin film is formed on a substrate facing the target. The pulsed laser deposition is effective for a target material that absorbs the irradiating laser at a great degree.

Moreover, the pulsed laser deposition does not require a plasma gas, such as argon, necessary for sputtering. In addition, the target composition can be transferred to the film on the substrate, and therefore the film having the target composition can be easily formed.

The moisture content of the transparent heat-ray reflective film of the present embodiment is preferably within the predetermined range. In the method for manufacturing the transparent heat-ray reflective film of the present embodiment, therefore, the moisture content of the atmosphere in the film formation step is preferably controlled. In the case where the moisture content of the atmosphere during film formation is controlled, the moisture released from the target is preferably also considered. In order to reduce the moisture released from the target, a smaller target is preferable. For the pulsed laser deposition, a tablet target having a diameter of approximately 20 mm can be used. Therefore, the pulsed laser deposition can be suitably used.

Use of one target composed of a compound including an alkali metal element and tungsten constituting the alkali tungsten bronze as the target is the simplest method. However, film formation may be performed in a manner such that a target including an alkali metal element and a target including tungsten are both used to simultaneously or alternately form two or more layers. Alternatively, two or more targets having different compositions of an alkali metal element and tungsten may be used to simultaneously or alternately form two or more films, thereby adjusting the composition ratio of the elements included in the film.

Since the duty ratio of the laser applied to the target is small in the pulsed laser deposition, it is not necessary to cool the target. Since the target used in the pulsed laser deposition does not need to be cooled, a backing plate provided to the target used for sputtering is not necessary.

Oxygen, nitrogen, carbon, and the like included in the target may be discharged during the film formation, and therefore can be adjusted with a reactive gas fed during the film formation. In the method for manufacturing the transparent heat-ray reflective film of the present embodiment, as the reactive gas, for example, oxygen can be used.

In the method for manufacturing the transparent heat-ray reflective film of the present embodiment, the moisture is not preferably incorporated into the film during film formation. Therefore, a continuous thin crystal film including alkali tungsten bronze is preferably formed on a surface of a substrate in film formation conditions under which the moisture from the inner wall of the vacuum chamber, the target, or the like does not enter the continuous thin crystal film.

Then, the ultimate vacuum in the film formation step, more specifically at pre-sputtering of the target or before introducing a reactive gas, is preferably lower than 1 × 10⁻⁴ Pa, and more preferably lower than 1 × 10⁻⁵ Pa.

The partial pressure of water in the atmosphere during the film formation in the film formation step is preferably lower than 1 × 10⁻⁴ Pa, and more preferably lower than 1 × 10⁻⁵ Pa.

In order to achieve the ultimate vacuum and the partial pressure of water during the film formation, a cryopump, a cryopanel, a cryocoil, or the like, which has a high exhaust speed of moisture, is preferably used in combination with baking in a general vacuum chamber. Further, reduction in a surface area of the inner wall of the vacuum chamber, pre-sputtering of the target performed, or reduction in a volume of the target can increase the degree of vacuum and is effective for reducing the partial pressure of water. When the chamber is open to the atmosphere at the time of mounting a substrate or a target, the vacuum chamber or the like is preferably heated to minimize the adsorption of the moisture as much as possible

In the pulsed laser deposition, a processing gas or a reactive gas is introduced as needed. In the method for manufacturing the transparent heat-ray reflective film of the present embodiment, oxygen can be used as a reactive gas.

The oxygen serving as a reactive gas introduced during the film formation has the purity of preferably at least 4 N or greater, and more preferably 5 N or greater.

In the film formation device for the pulsed laser deposition, a target is set in a vacuum chamber, and a substrate is set in a position facing the target in the vacuum chamber. A laser source used for ablation of the target is disposed outside the vacuum chamber and can apply laser light to the target. Moreover, the film formation device for the pulsed laser deposition may have a mechanism for rotating or swinging the target so that only one position of the target is not irradiated with laser.

The vacuum chamber may have a configuration in which a baking heater is provided, and film formation is performed while heating at 200°C or higher. In addition, a substrate heating mechanism, which heats the substrate during the film formation step, may be provided. As a heating device in the substrate heating mechanism, at least one selected from the group consisting of a halogen lamp heater, an SiC heater, a sheath heater, and the like can be used.

The film formation device may include a rotation mechanism that rotates a substrate so that a film having a uniform thickness is formed on a surface of the substrate. Therefore, the substrate can be rotated by the rotation mechanism, but revolving of the substrate is also effective for making the film thickness uniform.

An exhaust pump can be connected to the vacuum chamber. As the exhaust pump, multiple types of exhaust pumps, which can be used by switching between the exhaust pumps according to the degree of vacuum in the vacuum chamber, such as a dry pump and a turbo molecular pump, may be provided.

The case where the transparent heat-ray reflection film is produced by pulsed laser deposition has been mainly described as an example. However, the present invention is not limited to the above embodiment, and film formation conditions and the like are selected according to a film formation method.

### (3) Other steps

The method for manufacturing the transparent heat-ray reflective film of the present embodiment may include, other than the film formation step, a heat treatment step of performing a heat treatment on the film obtained after the film formation.

The heat treatment step after the film formation is preferably performed in the atmosphere that is a vacuum atmosphere, an atmosphere in which an inert gas is introduced into a vacuum atmosphere, or an inert gas atmosphere. As the inert gas, argon or nitrogen can be used. In the case where the inert gas is used, a small amount of hydrogen may be added to the inert gas.

In the film formation step, the substrate may be heated to generate alkali tungsten bronze crystals at the same time as film formation.

Alternatively, a film in an amorphous state or a state in which amorphous and crystalline states are mixed is formed in the film formation step, and the above-described heat treatment is performed to obtain the film including the desired alkali tungsten bronze crystals.

In the case where the heat treatment step is performed, a heat treatment temperature is not particularly limited, but the heat treatment step is preferably performed at the heat treatment temperature of 350°C or higher and lower than 1,000°C.

The transparent heat-ray reflective film obtained by the method for manufacturing the transparent heat-ray reflective film of the present embodiment, and the support supporting the transparent heat-ray reflective film can be applied for windows of automobiles or buildings, or various infrared reflective parts, as a transparent heat-ray reflective member. Therefore, the substrate used in the method for manufacturing the transparent heat-ray reflective film of the present embodiment is not particularly limited and may be selected according to the intended use or the like. For example, a glass substrate or a resin substrate can be used.

### EXAMPLES

The present invention will be specifically described through specific examples hereinafter, but the present invention is not limited to these examples.

### (1) Regarding evaluation methods

### (1-1) Surface resistance

The surface resistance of the obtained film was measured and calculated using Hiresta-UX and Loresta-GX manufactured by Mitsubishi Chemical Corporation.

### (1-2) Film thickness

The film thickness of the obtained film was measured by an optical profiler (NewView 6200, manufactured by Zygo).

### (1-3) Measurement of powder X-ray diffraction pattern

The powder X-ray diffraction pattern (XRD pattern) of the obtained film was measured by D2PHASER X-ray diffraction analyzer of BRUKER AXS SE using Cu-Kα rays.

### (1-4) Visible light transmittance, solar radiation transmittance, and near-infrared reflectance

As the optical characteristics of the obtained film, the transmittance and 8° incident diffusion reflectance were measured by a spectrophotometer V-670 (manufactured by JASCO Corp.) to obtain a transmittance spectrum and a reflectance spectrum. Using spectroscopic data of transmittance and reflectance, visible light transmittance (VLT) and solar radiation transmittance (ST) at a wavelength of 300 nm or longer and 2,500 or shorter were determined in accordance with JIS R 3106 (2019). Moreover, reflectance (R₁₄₀₀) at a wavelength of 1,400 nm, which was an infrared reflectance, was determined from the obtained reflectance spectrum.

### (1-5) Composition and amount of localized electrons

The quantitative composition of the alkali tungsten bronze in the obtained film was measured using an X-ray photoelectron spectrometer (XPS) (Versa Probe II, manufactured by ULVAC-PHI, INCORPORATED). The number ratio of W⁵⁺ to all of the W atoms was determined from the area ratio obtained by peak separation of W4f. The quantity of the localized electrons was estimated assuming that one localized electron was incidental to each W⁵⁺.

### (1-6) Moisture content

The moisture content of the obtained film was determined by peak separation of the O1s XPS spectrum. In the O1s spectrum, the component attributed to the O-H₂ bond generally appears at the position where binding energy is the largest. When the localized electron W⁵⁺ is present, the charge distribution of O adjacent to W⁵⁺ is affected by W⁵⁺, and the binding energy is changed. Therefore, it is appropriate to perform peak separation considering the contribution of W⁵⁺ when the peak separation of O1s is performed (Non-Patent Document 5).

In the case where W⁵⁺ is present, the O1s peak is separated into 4 components (O-W⁶⁺, O-W⁵⁺(1), O-W⁵⁺(2), and O-H₂). The contributions of O-H, O-C, and O=C are superimposed on the O-W⁵⁺(1) of the second peak and the O-W⁵⁺(2) of the third peak. The contributions of O-C and O=C can be generally suppressed to a sufficiently small level when a sample is handled in a sufficiently careful manner in XPS. The contribution of the O-H₂ bond was determined as the fourth component in the vicinity of 532.80 eV. The moisture content (molar ratio) of the film was determined by multiplying the area ratio of the O-H₂ peak to the O1s peak by the atomic ratio of O in the film.

### [Example 1]

### (Target production step)

A cesium carbonate aqueous solution and tungsten trioxide hydrate were mixed and kneaded at a ratio Cs/W of 0.33, where Cs/W was the ratio of an amount of cesium (Cs) to an amount of tungsten (W). The resultant mixture was dried in the air at 100°C for 12 h to thereby produce a precursor.

After heating the precursor to 800°C in the 5 vol.% H₂-95 vol.% N₂ gas stream and maintaining the temperature at 800°C for 1 hour, the precursor was gradually cooled to room temperature. After the gradual cooling, a dark navy blue composite tungsten oxide powder (referred to as CsWO powder hereinafter) was obtained.

The CsWO powder was loaded in a hot press device and was sintered in the vacuum atmosphere under the conditions such that the temperature was 950°C, and the pressing force was 250 kgf/cm², thereby producing a CsWO sintered compact. As a result of chemical analysis of the sintered compact composition, Cs/W, which was a ratio of an amount of Cs and an amount of W, was 0.32. The oxide sintered compact was cut by machining to have a diameter of 20 mm and a thickness of 4 mm, thereby producing a CsWO target. Film formation by pulsed laser deposition does not require a backing plate for cooling, as a duty ratio of the irradiating laser is significantly small.

### (Film formation step)

In the film formation step, a pulsed laser deposition device (PAC-LMBE, manufactured by PASCAL Co., Ltd.) was used. The pulsed laser deposition device (also referred to as the "PLD device" hereinafter) includes a load lock chamber for replacing a substrate and a target in a vacuum chamber so that the substrate and the vacuum chamber can be replaced without directly opening the vacuum chamber to the atmosphere. Therefore, the adsorption of moisture to the inner wall of the vacuum chamber can be minimized.

As irradiating laser of the PLD device, KrF laser (wavelength: 248 nm, pulse width: 25 ns) was used, and the irradiation energy applied to the target was set to 150 mJ using the power control of the laser and an optical attenuator.

A baking heater is wound around the vacuum chamber of the PLD device so that baking can be performed at 200°C or higher. The exhaust pump includes a dry pump and a turbo molecular pump, which can exhaust the vacuum chamber to a high degree of vacuum.

Further, a halogen lamp heater is provided to the PLD device as a substrate heating mechanism. The substrate is rotated by a rotation mechanism.

The above described CsWO target having the diameter of 20 mm and a synthetic quartz substrate of 1 inch × 0.7 mm were introduced into the vacuum chamber from the load lock chamber. After exhausting the vacuum chamber until ultimate vacuum of the vacuum chamber reached the order of 10⁻⁶ Pa, the inner atmosphere of the vacuum chamber was exhausted until the degree of vacuum reached the order of 10⁻⁵ Pa, while the temperature of the substrate-heating halogen heater inside the vacuum chamber was controlled and kept at 720°C.

During the film formation step, the target was rotated or swung so that a laser spot was not applied to only one position of the target.

With a shutter disposed immediately above the target was kept closed, laser was pre-shot to the target at 4 Hz for 20 minutes (pre-laser irradiation before film formation) without introducing a reactive gas, thereby preforming pre-sputtering.

Thereafter, water molecules released from the target and the surroundings of the target were discharged. For the measurement of the partial pressure of water, a quadrupole mass spectrometer (manufactured by HORIBA STEC, Co., Ltd.) was used.

Subsequently, an oxygen gas having the purity of 5 N, which was a reactive gas, was introduced until the gas pressure reached the set gas pressure depicted in the column of "partial pressure of oxygen" in Table 1. When the oxygen gas was introduced, the opening degree of the main valve of the turbo molecular pump was reduced to control the exhaust speed.

Then, the shutter immediately above the target was open, and the irradiating laser was applied at 3 Hz for 30 minutes, which are the conditions depicted in the column of "KrF laser irradiation conditions" in Table 1. After the laser irradiation was performed, the halogen lamp heater and the introduction of oxygen were stopped, and the substrate on which the film was formed was taken out after the temperature of the substrate was reduced to 100°C or lower.

The ultimate vacuum inside the vacuum chamber before performing pre-sputtering, as well as the partial pressure of water and the partial pressure of oxygen inside the vacuum chamber during the film formation step, are all presented in Table 1.

### (Evaluation)

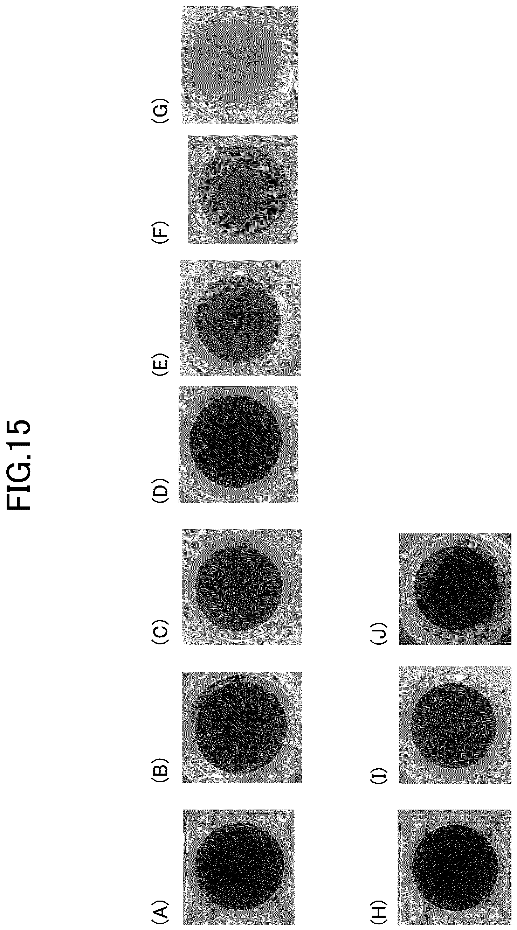

It was visually observed that the resultant film was in vivid blue, and had visible light transmittance. The film thickness measured by the optical profiler was 264 nm. The photograph depicting the appearance of the obtained film (actual photograph) is presented in (A) of Fig. 15.

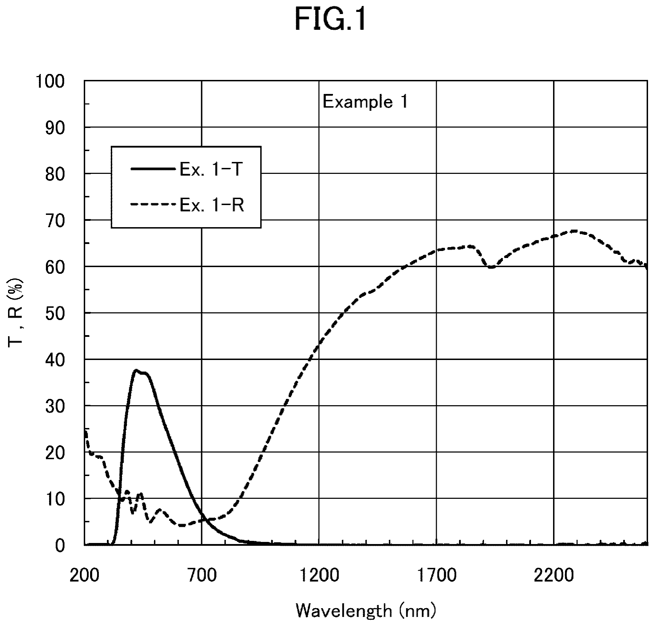

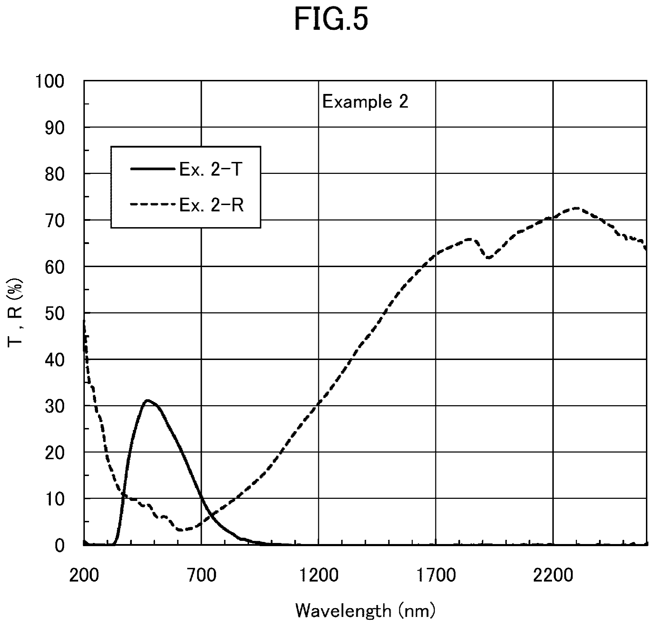

The spectral characteristics of the obtained film were measured, and as a result, the transmittance and reflectance profiles as depicted in Fig. 1 were obtained. In Fig. 1, "Ex. 1-T" indicates the transmittance profile, and "Ex. 1-R" indicates the reflectance profile. The transmittance and reflectance profiles of other Examples and Comparative Examples in Figs. 5 to 13 are indicated in the same manner.

As presented in Table 1, it was confirmed that the obtained transparent heat-ray reflective film had the visible light transmittance (VLT) of 23.8%, and therefore had visible light transmittance. On the other hand, it was found that the reflectance of the transparent heat-ray reflective film sharply increased at wavelengths of near-infrared rays, and reflectance became large at a wavelength of 1,400 nm, i.e., R₁₄₀₀ =54.2%. This large near-infrared reflection was considered to be due to plasmonic reflection realized by the free electrons in the film. It was found as the result of the near-infrared reflection that solar radiation transmittance (ST) was low, i.e., 10.4%, and the film had very effective heat-ray reflection performance.

The composition of the film was determined by quantitative analysis of Cs, W, and O by an XPS surface analyzer. As a result, as presented in Table 1, the ratios of the above atoms were Cs/W = 0.32, and O/W = 2.76, and therefore it was found that a sufficient amount of Cs was present in the film, and oxygen deficiency partly occurred.

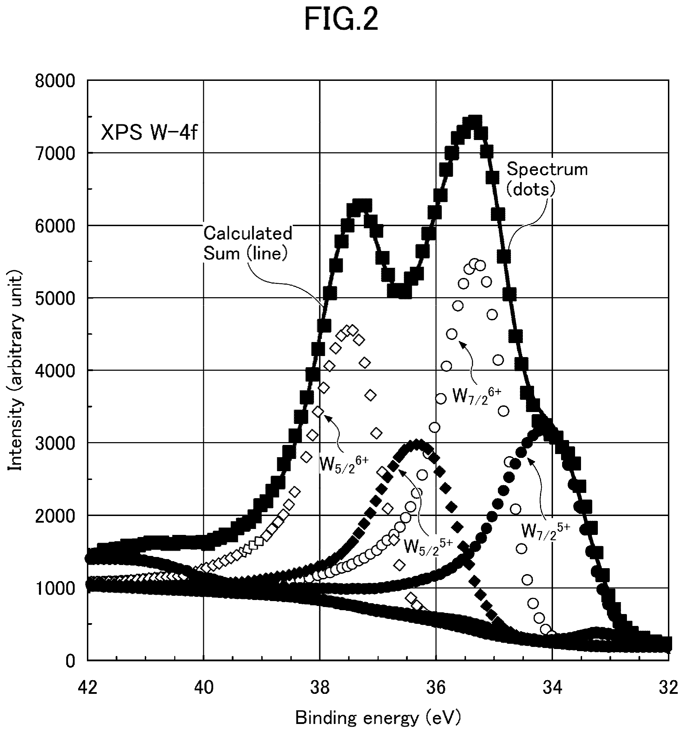

Moreover, by performing peak separation of a photoelectron spectrum of W4f orbital electrons by XPS, it was found that a large amount of 5 valent W⁵⁺ was included as illustrated in Fig. 2. Assuming that the peak area is proportional to the abundance ratio, it was found that 42.7% of all W atoms were accompanied by localized electrons W⁵⁺.

Next, when the surface resistance of the transparent heat-ray reflective film was measured, a large value of 6.56 × 10⁹ Q/sq was obtained, and therefore it was found that the transparent heat-ray reflective film was non-conductive even though it was a film exhibiting plasmonic reflection, i.e., the continuous film of the material that realized plasmonic reflection.

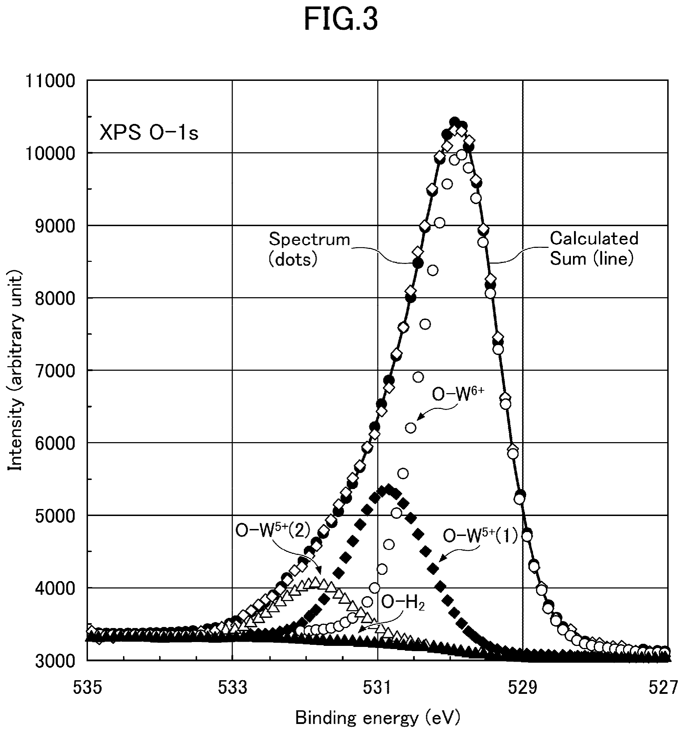

The moisture in the transparent heat-ray reflective film was determined by peak separation of the O1s spectrum of XPS. As depicted in Fig. 3, the O1s peak was separated into 4 components, and the O-H₂ bond was determined as a component in the vicinity of 532.80 eV. The area ratio of 0.20% in the O1s peak was attributed to the O-H₂ bond, and the molar ratio of the moisture in the film of Example 1 was determined as 0.12 mol% by multiplying the area ratio by the atomic ratio of O in the film. Specifically, it was found that the introduction of the moisture into the film was minimized to an extremely low level by adjusting the PLD film formation conditions as described above.

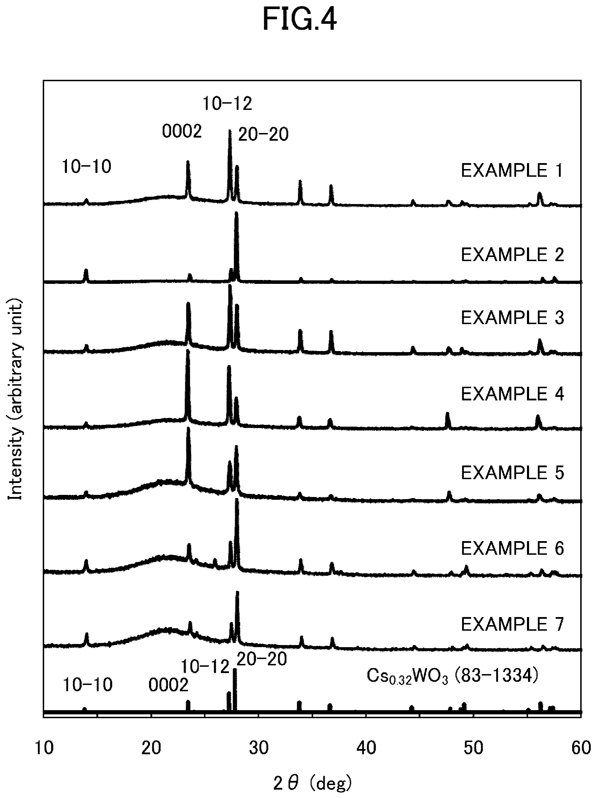

Fig. 4 is a polycrystalline XRD pattern of the transparent heat-ray reflective film.

The positions of the diffraction line of the XRD pattern depicted in Fig. 4 basically indicate the presence of hexagonal tungsten bronze. Therefore, in Tables 1 and 2, HTB referring to hexagonal tungsten bronze is presented in the column of the confirmed crystalline phase. However, the intensity distribution of the diffraction line indicates the presence of the strong orientation. While the peak of the basal plane (0002) and the (10-12) peak in the vicinity of the basal plane have high intensity, the intensity of the (20-20) peak that is one of the prismatic planes vertical to the basal is relatively low. Specifically, it was confirmed that the strong (0002) orientation was present.

In order to quantitatively evaluate the above orientation, the ratio of the diffraction intensity of the (0002) plane, which was the c-plane, to the diffraction intensity of the (20-20) plane, which was the a-plane, was determined as 1 in the powder pattern (ICDD83-1333) of Cs_{0.32}WO₃ without crystal orientation, presented at the lowest row of Fig. 4.

Using the diffraction intensity ratio as a reference, the diffraction intensity ratio of the (0002) plane, which was the C-plane, to the diffraction intensity of the (20-20) plane of the alkali tungsten bronze included in the measured transparent heat-ray reflective film of the present example was presented in the column of "(0002)/(20-20)" in Table 2.

Similarly, the ratio of the diffraction intensity of the (10-12) plane to the diffraction intensity of the (20-20) plane, which was the a-plane, in the powder pattern (ICDD83-1333) of Cs_{0.32}WO₃ without crystal orientation presented at the lowest row of Fig. 4 was determined as 1.

Using the diffraction intensity ratio as a reference, the ratio of the diffraction intensity of the (10-12) plane in the vicinity of the basal plane to the diffraction intensity of the (20-20) plane, which was the a-plane, of the alkali tungsten bronze included in the measured transparent heat-ray reflective film of the present example is presented in the column "(10-12)/(20-20)" of Table 2.

The observed values of the diffraction intensity ratios were respectively 4.502 times and 4.103 times the reference values, and strong c-axis orientation was statistically confirmed.

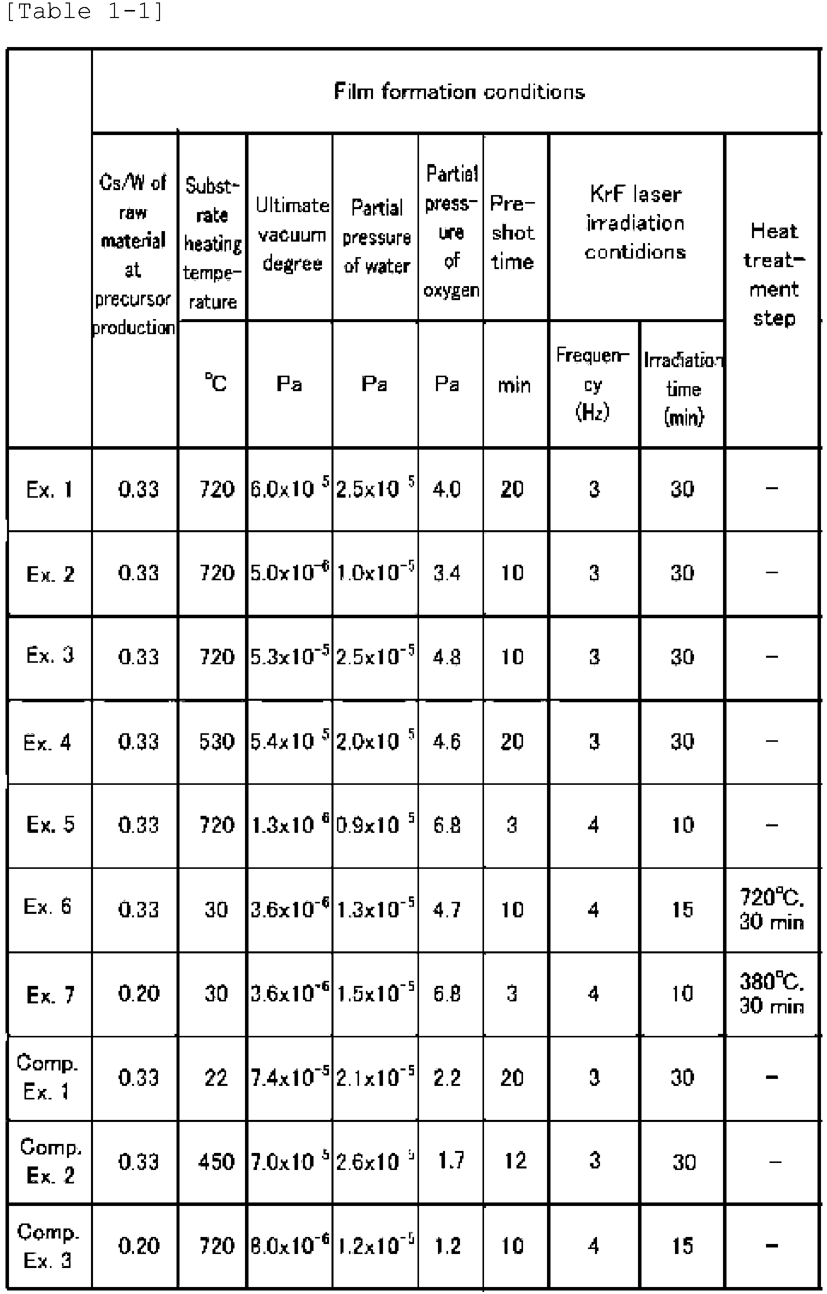

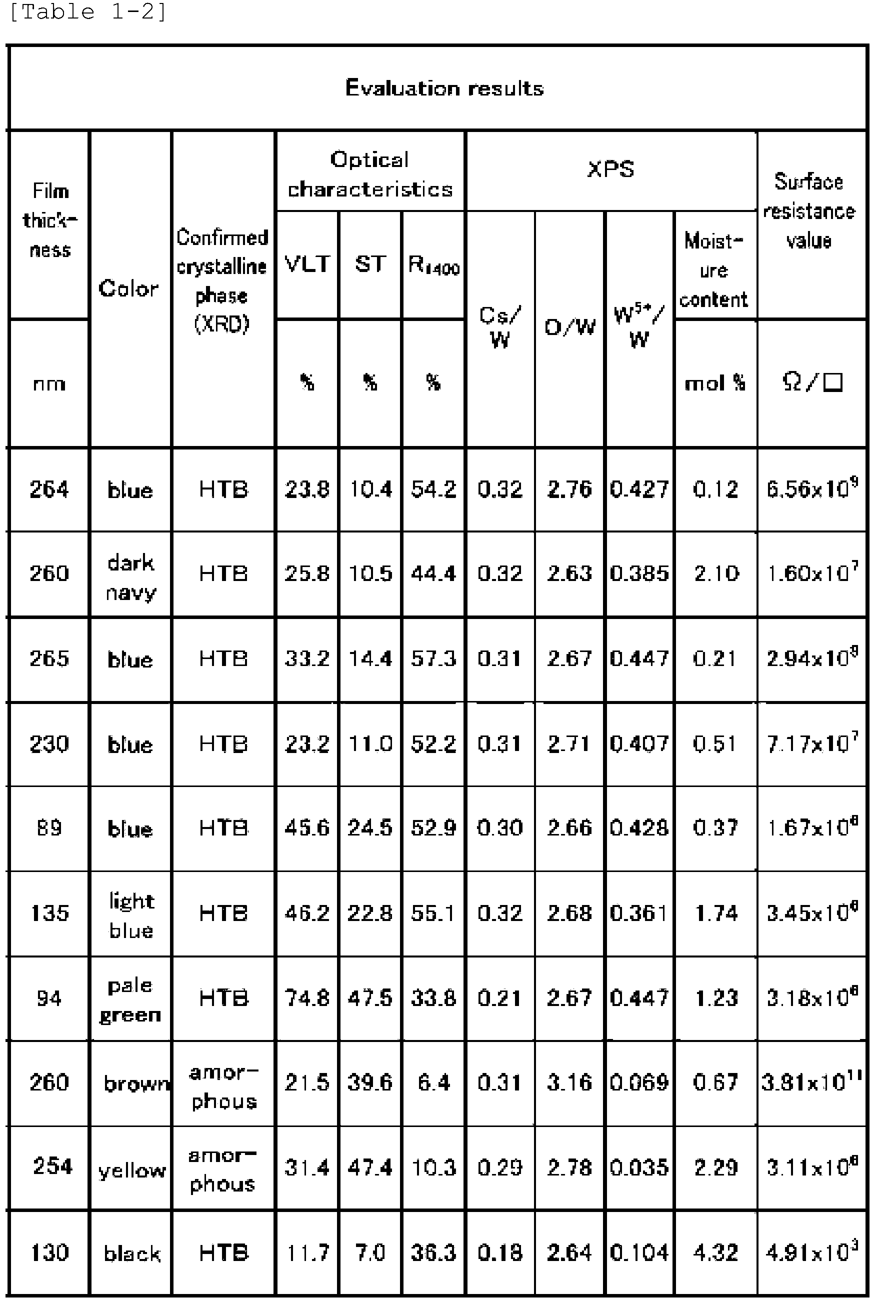

**[Table 2]**

| | Confirmed crystalline phase | (0002)/(20-20) | (10-12)/(20-20) | Orientation |
|---|---|---|---|---|
| Ex. 1 | HTB | 4.502 | 4.103 | c-axis orientation |
| Ex. 2 | HTB | 0.472 | 0.426 | weak a-axis orientation |
| Ex. 3 | HTB | 4.200 | 3.058 | c-axis orientation |
| Ex. 4 | HTB | 9.837 | 4.345 | c-axis orientation |
| Ex. 5 | HTB | 5.311 | 1.647 | c-axis orientation |
| Ex. 6 | HTB | 1.788 | 1.046 | weak c-axis orientation |
| Ex. 7 | HTB | 2.097 | 1.112 | c-axis orientation |
| Ref. Cs_{0.32}WO₃ | HTB | 1 | 1 | - |

### [Example 2]

A transparent heat-ray reflective film was formed under the same conditions and in the same process as in Example 1, except that the ultimate vacuum, the partial pressure of water, the partial pressure of oxygen, and the pre-shot time in the film formation step were changed to the conditions presented in Table 1.

### (Evaluation)

It was visually observed that the resultant film was in dark navy blue, and had visible light transmittance. The photograph depicting the appearance of the obtained film (actual photograph) is presented in (B) of Fig. 15.

The film thickness of the transparent heat-ray reflective film measured was 260 nm.

The spectral characteristics of the obtained transparent heat-ray reflective film are presented in Table 1 and Fig. 5. It was found from Fig. 5 and Table 1 that, while the obtained transparent heat-ray reflective film had visible light transmittance of VLT = 25.8%, the transparent heat-ray reflective film had the large near-infrared reflection of R₁₄₀₀ = 44.4%. It was found as the result of the near-infrared reflection that solar radiation transmittance was low, i.e., ST = 10.5%, and the film had very effective heat-ray reflection performance.

The atomic ratios in the transparent heat-ray reflective film measured by the XPS surface analyzer were Cs/W = 0.32, and O/W = 2.63, and therefore it was found that a sufficient amount of Cs was present in the film, and oxygen deficiency partially occurred. Moreover, W⁵⁺/W = 0.385 (molar ratio) was obtained from the separation of the W4f peak of XPS, and it was found that a large amount of localized electrons was included. Specifically, it was found that 38.5% of all of the W atoms in terms of the number ratio were companied by localized electrons W⁵⁺.

The surface resistance of the film measured was 1.60 × 10⁷ Ω/sq, and therefore it was found that the transparent heat-ray reflective film was non-conductive even though it was a film exhibiting plasmonic reflection, i.e., the continuous film of the material that realized plasmonic reflection.

The moisture content of the film determined from the quantitative value of O and the peak separation of the O1s spectrum of XPS was 2.10 mol%, and therefore it was confirmed that the introduction of the moisture into the film was minimized to a low level.

The polycrystalline XRD pattern of the film was basically a pattern of hexagonal tungsten bronze, as depicted in Fig. 4, and therefore it was confirmed that the diffraction intensity of the (20-20) plane, which was the a-plane, was greater than the diffraction intensity of the (0002) plane, which was the c-plane. Then, as also presented in Table 2, the diffraction intensity ratio (0002)/(20-20) and the diffraction intensity ratio (10-12)/(20-20) were respectively 0.472 times and 0.426 times the reference value, and therefore it was found that weak a-axis orientation was present.

### [Example 3]

A transparent heat-ray reflective film was formed under the same conditions and in the same process as in Example 1, except that the ultimate vacuum, the partial pressure of oxygen, and the pre-shot time in the film formation step were changed to the conditions presented in Table 1.

### (Evaluation)

It was visually observed that the resultant film was blue, and had visible light transmittance. The photograph depicting the appearance of the obtained film (actual photograph) is presented in (C) of Fig. 15.

The film thickness of the transparent heat-ray reflective film measured was 265 nm.

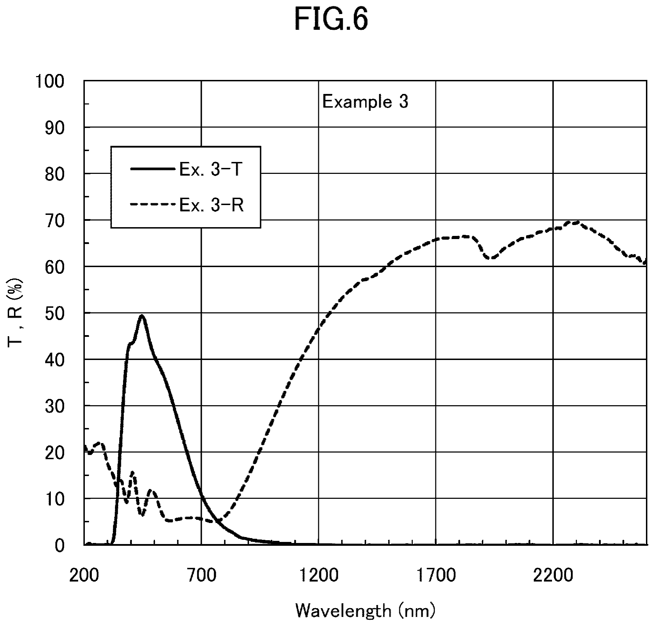

The spectral characteristics of the obtained transparent heat-ray reflective film are presented in Table 1 and Fig. 6. It was found from Fig. 6 and Table 1 that, while the obtained transparent heat-ray reflective film had visible light transmittance of VLT = 33.2%, the transparent heat-ray reflective film had the large near-infrared reflection of R₁₄₀₀ = 57.3%. It was found as the result of the near-infrared reflection that solar radiation transmittance was low, i.e., ST = 14.4%, and the film had very effective heat-ray reflection performance.

The atomic ratios in the transparent heat-ray reflective film measured by the XPS surface analyzer were Cs/W = 0.31, and O/W = 2.67, and therefore it was found that a sufficient amount of Cs was present in the film, and oxygen deficiency partially occurred. Moreover, W⁵⁺/W = 0.447 (molar ratio) was obtained from the separation of the W4f peak of XPS, and it was found that a large amount of localized electrons was included. Specifically, it was found that 44.7% of all of the W atoms in terms of the number ratio were accompanied by localized electrons W⁵⁺.

The surface resistance of the film measured was 2.94 × 10⁸ Ω/sq, and therefore it was found that the transparent heat-ray reflective film was non-conductive even though it was a film exhibiting plasmonic reflection, i.e., the continuous film of the material that realized plasmonic reflection.

The moisture content of the film determined from the quantitative value of O and the peak separation of the O1s spectrum of XPS was 0.21 mol%, and therefore it was confirmed that the introduction of the moisture into the film was minimized to a low level.

The polycrystalline XRD pattern of the film was basically a pattern of hexagonal tungsten bronze, as depicted in Fig. 4, and therefore it was confirmed that the diffraction intensity of the (0002) plane, which was the c-plane, was greater than the diffraction intensity of the (20-20) plane, which was the a-plane. Then, as also presented in Table 2, the diffraction intensity ratio (0002)/(20-20) and the diffraction intensity ratio (10-12)/(20-20) were respectively 4.200 times and 3.058 times the reference value, and therefore it was found that strong c-axis orientation was present.

### [Example 4]

A transparent heat-ray reflective film was formed under the same conditions and in the same process as in Example 1, except that the substrate heating temperature, the ultimate vacuum, the partial pressure of water, and the partial pressure of oxygen in the film formation step were changed to the conditions presented in Table 1.

### (Evaluation)

It was visually observed that the resultant film was blue, and had visible light transmittance. The photograph depicting the appearance of the obtained film (actual photograph) is presented in (D) of Fig. 15.

The film thickness of the transparent heat-ray reflective film measured was 230 nm.

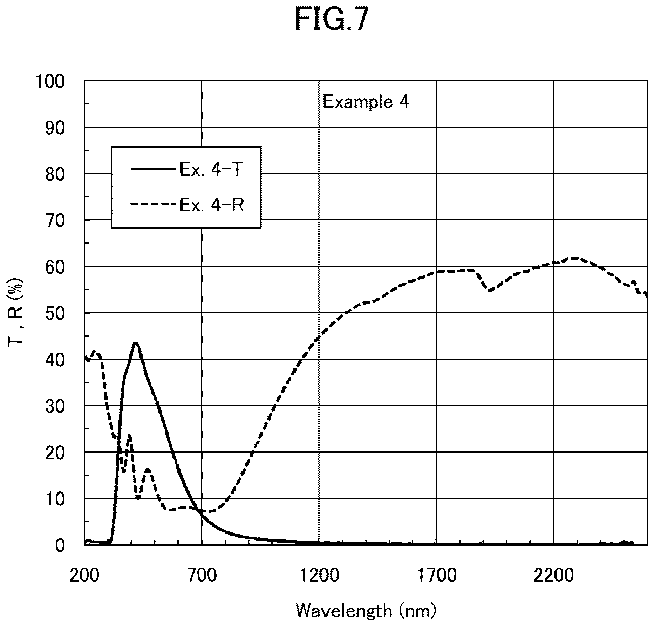

The spectral characteristics of the obtained transparent heat-ray reflective film are presented in Table 1 and Fig. 7. It was found from Fig. 7 and Table 1 that, while the obtained transparent heat-ray reflective film has visible light transmittance of VLT = 23.2%, the transparent heat-ray reflective film had the large near-infrared reflection of R₁₄₀₀ = 52.2%. It was found as the result of the near-infrared reflection that solar radiation transmittance was low, i.e., ST = 11.0%, and the film had very effective heat-ray reflection performance.

The atomic ratios in the transparent heat-ray reflective film measured by the XPS surface analyzer were Cs/W = 0.31, and O/W = 2.71, and therefore it was found that a sufficient amount of Cs was present in the film, and oxygen deficiency partially occurred. Moreover, W⁵⁺/W = 0.407 (molar ratio) was obtained from the separation of the W4f peak of XPS, and it was found that a large amount of localized electrons was included. Specifically, it was found that 40.7% of all of the W atoms in terms of the number ratio were accompanied by localized electrons W⁵⁺.

The surface resistance of the film measured was 7.17×10⁷ Q/sq, and therefore it was found that the transparent heat-ray reflective film was non-conductive even though it was a film exhibiting plasmonic reflection, i.e., the continuous film of the material that realized plasmonic reflection.

The moisture content of the film determined from the quantitative value of O and the peak separation of the O1s spectrum of XPS was 0.51 mol%, and therefore it was confirmed that the introduction of the moisture into the film was minimized to a low level.

The polycrystalline XRD pattern of the film was basically a pattern of hexagonal tungsten bronze, as depicted in Fig. 4, and therefore it was confirmed that the diffraction intensity of the (0002) plane, which was the c-plane, was greater than the diffraction intensity of the (20-20) plane, which was the a-plane. Then, as also presented in Table 2, the diffraction intensity ratio (0002)/(20-20) and the diffraction intensity ratio (10-12)/(20-20) were respectively 9.837 times and 4.345 times the reference value, and therefore it was found that extremely strong c-axis orientation was present.

### [Example 5]

A transparent heat-ray reflective film was formed under the same conditions and in the same process as in Example 1, except that the ultimate vacuum, the partial pressure of water, the partial pressure of oxygen, the pre-shot time, and the KrF laser irradiation conditions in the film formation step were changed to the conditions presented in Table 1.

### (Evaluation)

It was visually observed that the resultant film was blue, and had visible light transmittance. The photograph depicting the appearance of the obtained film (actual photograph) is presented in (E) of Fig. 15.

The film thickness of the transparent heat-ray reflective film measured was 89 nm.

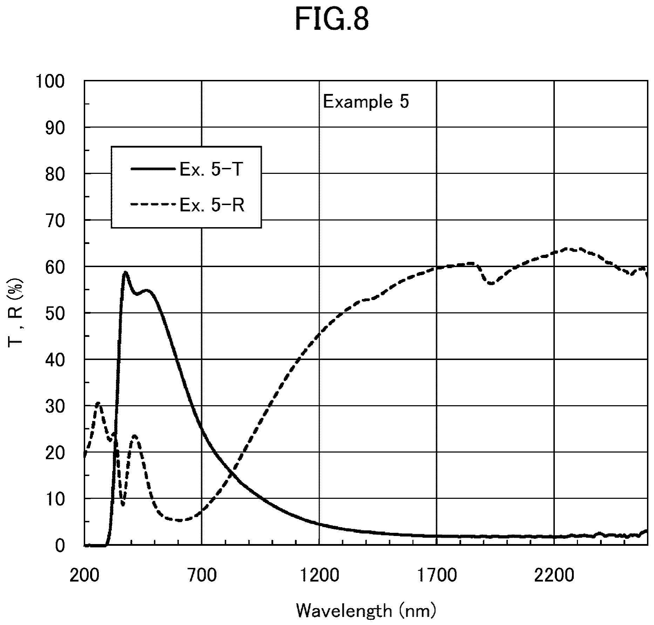

The spectral characteristics of the obtained transparent heat-ray reflective film are presented in Table 1 and Fig. 8. It was found from Fig. 8 and Table 1 that, while the obtained transparent heat-ray reflective film had high visible light transmittance of VLT = 45.6%, the transparent heat-ray reflective film had the large near-infrared reflection of R₁₄₀₀ = 52.9%. It was found as the result of the near-infrared reflection that solar radiation transmittance was low, i.e., ST = 24.5%, and the film had very effective heat-ray reflection performance.

The atomic ratios in the transparent heat-ray reflective film measured by the XPS surface analyzer were Cs/W = 0.30, and O/W = 2.66, and therefore it was found that a sufficient amount of Cs was present in the film, and oxygen deficiency partially occurred. Moreover, W⁵⁺/W = 0.428 (molar ratio) was obtained from the separation of the W4f peak of XPS, and it was found that a large amount of localized electrons was included. Specifically, it was found that 42.8% of all of the W atoms in terms of the number ratio were accompanied by localized electrons W⁵⁺.

The surface resistance of the film measured was 1.67 × 10⁶ Ω/sq, and therefore it was found that the transparent heat-ray reflective film was non-conductive even though it was a film exhibiting plasmonic reflection, i.e., the continuous film of the material that realized plasmonic reflection.

The moisture content of the film determined from the quantitative value of O and the peak separation of the O1s spectrum of XPS was 0.37 mol%, and therefore it was confirmed that the introduction of the moisture into the film was minimized to a low level.

The polycrystalline XRD pattern of the film was basically a pattern of hexagonal tungsten bronze, as depicted in Fig. 4, and therefore it was confirmed that the diffraction intensity of the (0002) plane, which was the c-plane, was greater than the diffraction intensity of the (20-20) plane, which was the a-plane. Then, as also presented in Table 2, the diffraction intensity ratio (0002)/(20-20) and the diffraction intensity ratio (10-12)/(20-20) were respectively 5.311 times and 1.647 times the reference value, and therefore it was found that strong c-axis orientation was present.

### [Example 6]

A transparent heat-ray reflective film was formed under the same conditions and in the same process as in Example 1, except that the substrate heating temperature, the ultimate vacuum, the partial pressure of water, the partial pressure of oxygen, the pre-shot time, and the KrF laser irradiation conditions in the film formation step were changed to the conditions depicted in Table 1.

After the film formation step, the oxygen pressure was stopped to be 0 Pa, and the film was subjected to a heat treatment step in which the film was heated up to 720°C in the vacuum chamber and the temperature was maintained for 30 minutes. Thereafter, the film was gradually cooled to room temperature.

Other than above, the transparent heat-ray reflective film was formed under the same conditions and in the same process as in Example 1.

### (Evaluation)

It was visually observed that the resultant film was light blue, and had visible light transmittance. The photograph depicting the appearance of the obtained film (actual photograph) is presented in (F) of Fig. 15.

The film thickness of the transparent heat-ray reflective film measured was 135 nm.

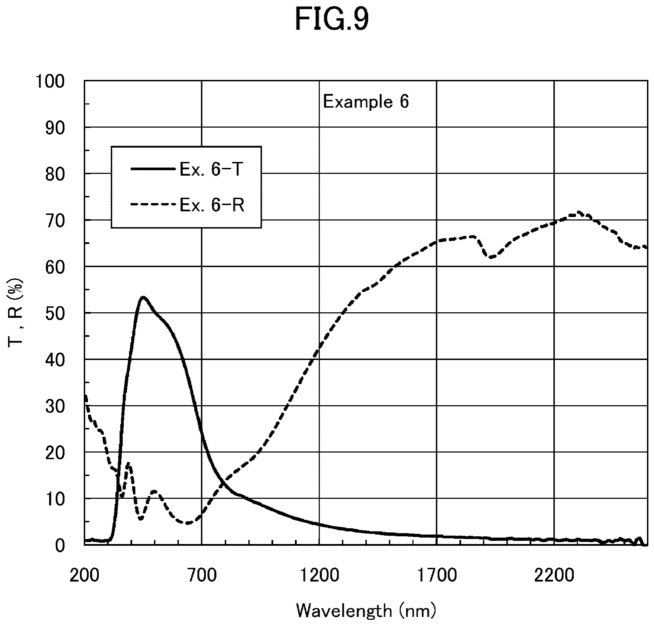

The spectral characteristics of the obtained transparent heat-ray reflective film are presented in Fig. 9. It was found from Fig. 9 and Table 1 that, while the obtained transparent heat-ray reflective film has visible light transmittance of VLT = 46.2%, the transparent heat-ray reflective film had the large near-infrared reflection of R₁₄₀₀ = 55.1%. It was found as the result of the near-infrared reflection that solar radiation transmittance was low, i.e., ST = 22.8%, and the film had effective heat-ray reflection performance.

The atomic ratios in the transparent heat-ray reflective film measured by the XPS surface analyzer were Cs/W = 0.32, and O/W = 2.68, and therefore it was found that a sufficient amount of Cs was present in the film, and oxygen deficiency partially occurred. Moreover, W⁵⁺/W = 0.361 (molar ratio) was obtained from the separation of the W4f peak of XPS, and it was found that a large amount of localized electrons was included. Specifically, it was found that 36.1% of all of the W atoms in terms of the number ratio were companied by localized electrons W⁵⁺.

The surface resistance of the film measured was 3.45 × 10⁶ Ω/sq, and therefore it was found that the transparent heat-ray reflective film was non-conductive even though it was a film exhibiting plasmonic reflection, i.e., the continuous film of the material that realized plasmonic reflection.

The moisture content of the film determined from the quantitative value of O and the peak separation of the O1s spectrum of XPS was 1.74 mol%, and therefore it was confirmed that the introduction of the moisture into the film was minimized to a low level.

It was confirmed that the polycrystalline XRD pattern of the film was basically a pattern of hexagonal tungsten bronze, as depicted in Fig. 4. Then, as also presented in Table 2, the diffraction intensity ratio (0002)/(20-20) and the diffraction intensity ratio (10-12)/(20-20) were respectively 1.788 times and 1.046 times the reference value, and therefore it was found that weak c-axis orientation was present.

### [Example 7]

When a precursor was produced in a target production step, a cesium carbonate aqueous solution and tungsten trioxide hydrate were mixed and kneaded at a ratio Cs/W of 0.20, where Cs/W was the ratio of an amount of cesium (Cs) to an amount of tungsten (W). Then, the kneaded product was dried under the same conditions as in Example 1, to thereby produce a precursor. A CsWO powder and a CsWO target were produced under the same conditions as in Example 1, except that the above-prepared precursor was used, and the prepared CsWO was provided to a film formation step.

Moreover, the substrate heating temperature, the ultimate vacuum, the partial pressure of water, the partial pressure of oxygen, the pre-shot time, and KrF laser irradiation conditions were changed to the conditions presented in Table 1.

After the film formation step, the oxygen pressure was stopped to be 0 Pa, and the film was subjected to a heat treatment step in which the film was heated up to 380°C in the vacuum chamber and the temperature was maintained for 30 minutes. Thereafter, the film was gradually cooled to room temperature.

Other than above, the transparent heat-ray reflective film was formed under the same conditions and in the same process as in Example 1.

### (Evaluation)

It was visually observed that the resultant film was pale green, and had visible light transmittance. The photograph depicting the appearance of the obtained film (actual photograph) is presented in (G) of Fig. 15.

The film thickness of the transparent heat-ray reflective film measured was 94 nm.

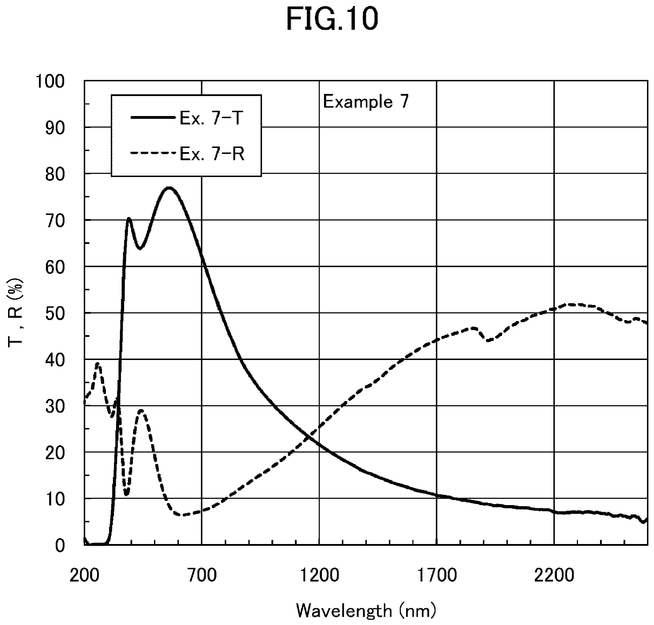

The spectral characteristics of the obtained transparent heat-ray reflective film are presented in Fig. 10. It was found from Fig. 10 and Table 1 that, while the obtained transparent heat-ray reflective film had high visible light transmittance of VLT = 74.8%, the transparent heat-ray reflective film had the near-infrared reflection of R₁₄₀₀ = 33.8%. It was found as the result of the near-infrared reflection that solar radiation transmittance was low, i.e., ST = 47.5%, and the film had effective heat-ray reflection performance.

The atomic ratios in the transparent heat-ray reflective film measured by the XPS surface analyzer were Cs/W = 0.21, and O/W = 2.67, and therefore it was found that a sufficient amount of Cs was present in the film, and oxygen deficiency partially occurred. Moreover, W⁵⁺/W = 0.447 (molar ratio) was obtained from the separation of the W4f peak of XPS, and it was found that a large amount of localized electrons was included. Specifically, it was found that 44.7% of all of the W atoms in terms of the number ratio were companied by localized electrons W⁵⁺.

The surface resistance of the film measured was 3.18×10⁶ Ω/sq, and therefore it was found that the transparent heat-ray reflective film was non-conductive even though it was a film exhibiting plasmonic reflection, i.e., the continuous film of the material that realized plasmonic reflection.

The moisture content of the film determined from the quantitative value of O and the peak separation of the O1s spectrum of XPS was 1.23 mol%, and therefore it was confirmed that the introduction of the moisture into the film was minimized to a low level.

It was confirmed that the polycrystalline XRD pattern of the film was basically a pattern of hexagonal tungsten bronze, as depicted in Fig. 4. Then, as also presented in Table 2, the diffraction intensity ratio (0002)/(20-20) and the diffraction intensity ratio (10-12)/(20-20) were respectively 2.097 times and 1.112 times the reference value, and therefore it was found that c-axis orientation was present.

### [Comparative Example 1]

A transparent heat-ray reflective film was formed under the same conditions and in the same process as in Example 1, except that the substrate heating temperature, the ultimate vacuum, the partial pressure of water, and the partial pressure of oxygen in the film formation step were changed to the conditions presented in Table 1.

In Comparative Example 1, the film was formed at the film formation temperature of 22°C and at the relatively low partial pressure of oxygen of 2.2 Pa.

### (Evaluation)

It was visually observed that the resultant film was dark brown. The photograph depicting the appearance of the obtained film (actual photograph) is presented in (H) of Fig. 15.

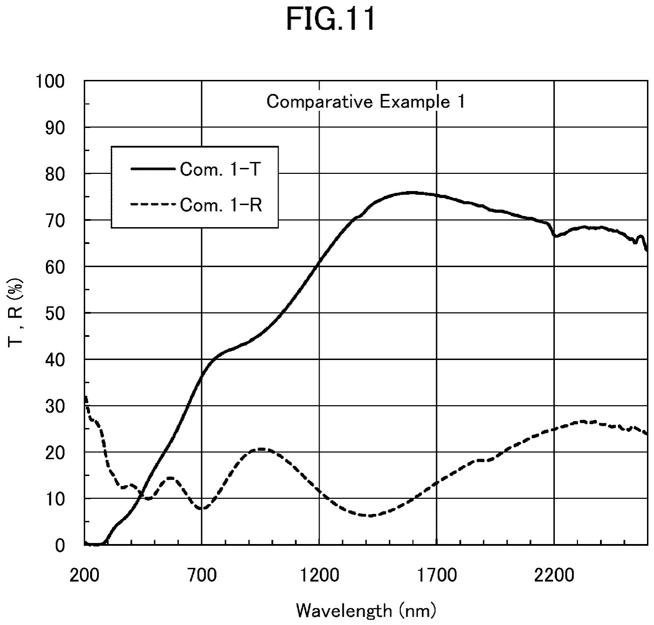

The spectral characteristics of the obtained transparent heat-ray reflective film are presented in Table 1 and Fig. 11. It was confirmed from Fig. 11 and Table 1 that the film had transmittance at visible wavelengths, i.e., VLT = 21.5%. However, the reflectance at near-infrared wavelengths was low, i.e., R₁₄₀₀ = 6.4%, and the solar radiation transmittance was high, i.e., ST = 39.6%. Thus, it was found that the film did not have effective heat-ray reflection performance. A rise in reflectance in the near-infrared region owing to the plasmonic reflection was not observed in the reflectance profile depicted in Fig. 10, and absorption in the near-infrared region was not also observed in the transmittance profile. Specifically, it was confirmed that the obtained film was not a continuous film of a material that realized plasmonic reflection.

The surface resistance of the film measured was 3.81 × 10¹¹ Ω/sq, and the film was non-conductive.

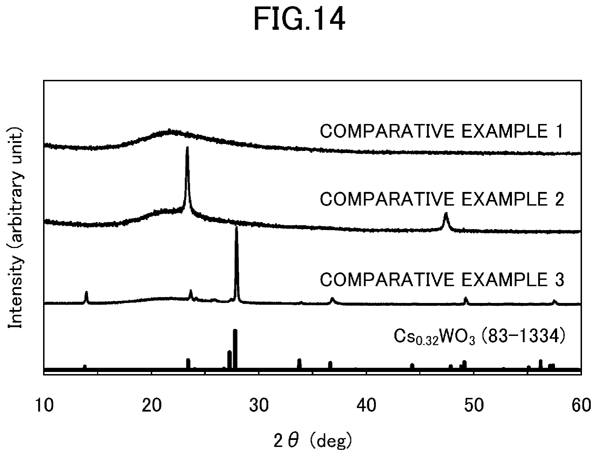

The XRD pattern of the obtained film indicated amorphous as depicted in Fig. 14.

It was found from the measurement by the XPS surface analyzer that the atomic ratio was Cs/W = 0.31, which indicated that an almost majority of Cs was inserted, but the atomic ratio of oxygen to tungsten was O/W = 3.16, which indicated oxygen was excessively incorporated. Moreover, W⁵⁺/W = 0.069 (molar ratio) was obtained from the separation of the W4f peak of XPS, and it was found that localized electrons were hardly present.

### [Comparative Example 2]

A transparent heat-ray reflective film was formed under the same conditions and in the same process as in Example 1, except that the substrate heating temperature, the ultimate vacuum, the partial pressure of water, the partial pressure of oxygen, and the pre-shot time in the film formation step were changed to the conditions presented in Table 1.

### (Evaluation)

It was confirmed that the obtained film was a glossy yellow film. The photograph depicting the appearance of the obtained film (actual photograph) is presented in (I) of Fig. 15.

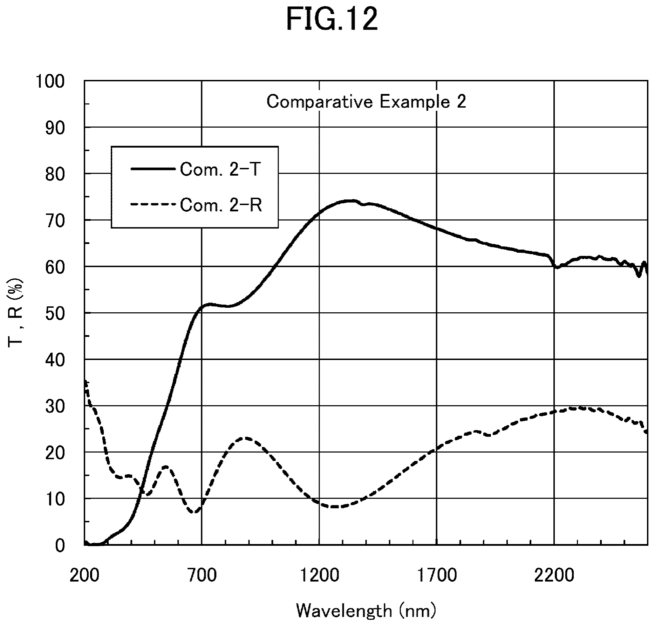

The spectral characteristics of the obtained transparent heat-ray reflective film are presented in Table 1 and Fig. 12. It was confirmed from Fig. 12 and Table 1 that the film had transmittance at visible wavelengths, i.e., VLT = 31.4%. However, the peak of the reflectance at near-infrared wavelengths appeared in the vicinity of 2,300 nm, and the reflectance at near-infrared wavelengths was low transmittance was high, i.e., ST = 47.4%, and therefore it was found that the film did not have effective heat-ray reflection performance. The absorption in the near-infrared region was not observed in the transmittance profile. Specifically, it was confirmed that the obtained film was not a continuous film of a material that realized plasmonic reflection.

The surface resistance of the film measured was 3.11 × 10⁶ Ω/sq, and the film was non-conductive.

The XRD pattern of the obtained film indicated amorphous as depicted in Fig. 14, but the diffraction lines (0002) and (0004) were observed in the vicinity of 23.4° and 47.8°, respectively, which indicated that crystallization with orientation along the hexagonal basal plane started to progress.

It was found from the measurement by the XPS surface analyzer that the atomic ratio was Cs/W = 0.29, which indicated that an almost majority of Cs was inserted, and the atomic ratio of oxygen to tungsten was O/W = 2.78, which indicated that oxygen defect partially occurred. Moreover, W⁵⁺/W = 0.035 (molar ratio) was obtained from the separation of the W4f peak of XPS, and it was found that localized electrons W⁵⁺ were hardly present.

### [Comparative Example 3]

A transparent heat-ray reflective film was formed under the same conditions and in the same process as in Example 7, except that the substrate heating temperature, the ultimate vacuum, the partial pressure of water, the partial pressure of oxygen, the pre-shot time, the KrF laser irradiation conditions in the film formation step were changed to the conditions presented in Table 1.

### (Evaluation)

It was confirmed that the obtained film was a photograph depicting the appearance of the obtained film (actual photograph) is presented in (J) of Fig. 15.

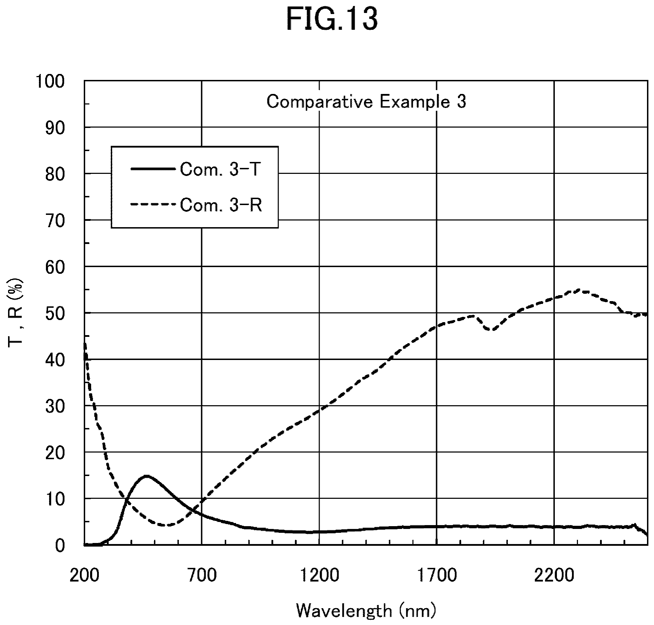

The spectral characteristics of the obtained transparent heat-ray reflective film are presented in Table 1 and Fig. 13. It was found from Fig. 13 and Table 1 that the film had a moderate level of reflectance at near-infrared wavelengths, i.e., R₁₄₀₀ = 36.3%, but had low transmittance at visible wavelengths, i.e., VLT = 11.7%. The solar radiation was low, i.e., ST = 7.0%, relative to the value of VLT, and it was found that the film had solar radiation shielding performance.

The surface resistance of the film measured was 4.91 × 10³ Ω/sq, and the film was conductive.

It was confirmed that the XRD pattern of the obtained film was a pattern of hexagonal tungsten bronze as depicted in Fig. 14.

It was found from the measurement by the XPS surface analyzer that the atomic ratio was Cs/W = 0.18, which indicated that an almost majority of Cs was inserted, and the atomic ratio of oxygen to tungsten was O/W = 2.64, which indicated that oxygen defect partially occurred. Moreover, W⁵⁺/W = 0.104 (molar ratio) was obtained from the separation of the W4f peak of XPS, and it was found that a small amount of localized electrons W⁵⁺ was present.

This application claims priority under Japanese Patent Application No. 2023-016778 filed February 7, 2023, and the entire contents of Japanese Patent Application No. 2023-016778 are incorporated herein by reference.

## Claims

1. A transparent heat-ray reflective film, comprising
a material that realizes plasmonic reflection, the transparent heat-ray reflective film being a continuous film of the material that realizes plasmonic reflection, and being non-conductive.

2. The transparent heat-ray reflective film according to claim 1,
wherein the material that realizes plasmonic reflection includes alkali tungsten bronze that provides a hexagonal crystal pattern in powder X-ray diffraction.

3. The transparent heat-ray reflective film according to claim 2,
wherein the alkali tungsten bronze is represented by a general formula: AₓW_{y}O_{z} (0.05 ≤ x/y ≤ 0.5, 2.5 ≤ z/y ≤ 3.0, and an element A includes at least one selected from the group consisting of Na, K, Rb, and Cs).

4. The transparent heat-ray reflective film according to claim 2,
wherein both free electrons and localized electrons are present in crystals of the alkali tungsten bronze, and a ratio of the localized electrons W⁵⁺ to all W atoms is 0.20 or greater.

5. The transparent heat-ray reflective film according to claim 2,
wherein a (0001) plane, which is a basal plane of a hexagonal crystal of the alkali tungsten bronze, is oriented in a direction parallel to a surface of the transparent heat-ray reflective film to form a preferred orientation, and a peak diffraction intensity ratio I₀₀₀₂/I₂₀₋₂₀ of an X-ray diffraction pattern is greater than a peak diffraction intensity ratio of a sample of the alkali tungsten bronze without crystal orientation.

6. The transparent heat-ray reflective film according to any one of claims 1 to 5,
wherein the transparent heat-ray reflective film has optical characteristics such that visible light transmittance is 5% or greater, and reflectance at a wavelength of 1,400 nm is 30% or greater.

7. The transparent heat-ray reflective film according to any one of claims 1 to 5,
wherein the transparent heat-ray reflective film has surface resistance of 10⁵ Q/sq or greater.

8. The transparent heat-ray reflective film according to any one of claims 1 to 5,
wherein a moisture content of the transparent heat-ray reflective film is 5.0 mol% or less.

9. The transparent heat-ray reflective film according to any one of claims 1 to 5,
wherein a film thickness of the transparent heat-ray reflective film is 10 nm or greater and 600 nm or less.

10. A method for manufacturing a transparent heat-ray reflective film, the method comprising:
a film formation step of forming a film of a material that realizes plasmonic reflection as a non-conductive continuous film through dry film formation.

11. The method for manufacturing the transparent heat-ray reflective film according to claim 10,
wherein the material that reflective plasma includes alkali tungsten bronze that provides a hexagonal crystal pattern in powder X-ray diffraction, and
the alkali tungsten bronze is represented by a general formula: AₓW_{y}O_{z} (0.05 ≤ x/y ≤ 0.5, 2.5 ≤ z/y ≤ 3.0, an element A including at least one selected from the group consisting of Na, K, Rb, and Cs).

12. The method for manufacturing the transparent heat-ray reflective film according to claim 11,
wherein the dry film formation is magnetron sputtering, ion-beam sputtering, direct current sputtering, radio frequency sputtering, pulse sputtering, dual magnetron sputtering, electron beam physical vapor deposition, or pulsed laser deposition, all of which use a target including an alkali metal element and tungsten constituting the alkali tungsten bronze.

13. The method for manufacturing the transparent heat-ray reflective film according to any one of claims 10 to 12,
wherein partial pressure of water during the film formation in the film formation step is lower than 1 × 10⁻⁴ Pa.

14. The method for manufacturing the transparent heat-ray reflective film according to any one of claims 10 to 12,
wherein an ultimate vacuum in the film formation step is lower than 1 × 10⁻⁴ Pa.
